(19)

Europäisches
Patentamt
European
Patent Office
Office européen
des brevets

(11)    EP 3 447 803 A2

(12)    **EUROPEAN PATENT APPLICATION**

(43) Date of publication:
**27.02.2019  Bulletin 2019/09**

(21) Application number: **18190780.9**

(22) Date of filing: **25.09.2008**

(51) Int Cl.:
*H01L 29/861* (2006.01)      *H01L 21/329* (2006.01)
*H01L 29/06* (2006.01)       *H01L 29/78* (2006.01)

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **26.09.2007  US 975467 P**
**23.01.2008  US 22968 P**
**28.04.2008  US 48336 P**

(62) Document number(s) of the earlier application(s) in accordance with Art. 76 EPC:
**08833488.3 / 2 232 559**

(71) Applicant: **STMicroelectronics N.V.**
**1228 Plan-les-Quates, Geneva (CH)**

(72) Inventors:
• ANKOUDINOV, Alexei
  Redmond, WA Washington 98052 (US)
• RODOV, Vladimir
  Seattle, WA Washington 98146 (US)

(74) Representative: **Martinez, Olivier Gildas**
**Page White & Farrer**
**Bedford House**
**John Street**
**London WC1N 2BF (GB)**

Remarks:
This application was filed on 24-08-2018 as a divisional application to the application mentioned under INID code 62.

(54)    **ADJUSTABLE FIELD EFFECT RECTIFIER**

(57)    There is provided an adjustable field effect rectifier comprising an epitaxial layer (420) of a first conductivity with a drain formed on one side of the epitaxial layer (420), a pair of wells (430) of a second conductivity, opposite to the first conductivity, spaced apart from one another, formed in the epitaxial layer (420) opposite the drain, a gate area (405) formed atop the epitaxial layer (420) opposite the drain, an opening (410) through the gate area (405), and a layer (440) of the first conductivity formed in the epitaxial layer (420) under the opening (410) shorted to the gate and the pair of wells, said layer (440) is configured to decrease a resistance of a top layer within the epitaxial layer (420) between the pair of wells (430) and the layer (440).

Figure 4

EP 3 447 803 A2

## Description

### Related Application

This application claims the benefit of provisional U.S. Patent Application S.N. 60/975,467, filed September 26, 2007, having the same title as the present application, provisional U.S. Patent Application S.N. 60/022,968, filed January 1 , 2008, entitled "Regenerative Building Block and Diode Bridge Rectifier," and provisional U.S. Patent Application S.N. 61/048,336, filed April 28, 2008, entitled "MOSFET with Integrated Field Effect Rectifier," all of which have the same inventors as the present application and are incorporated herein by reference in full for all purposes.

### Field of the Invention

The present invention relates generally to rectifiers, and more particularly relates to rectifiers using a Field Effect structure.

### BACKGROUND OF THE INVENTION

A rectifier is a two terminal device that is commonly used in electric circuits to conduct current in one direction and block current in the opposite direction. The main element of a rectifier is a potential barrier that controls current carrier flow depending on the sign of the potential applied to the external electrodes. Until recently only two major technologies were used to make rectifiers. In Schottky Barrier Diodes (SBD's), the potential barrier is created at the interface between a metal and a semiconductor. Such a barrier is defined by the difference between the work functions of the metal and the semiconductor that make the contact. SBD's provide very good low forward voltage drop (up to 0.4V), which is the major performance characteristic of a diode, but are known to have reliability problems. Due to the lack of carrier modulation they cannot withstand high forward current surges. Additional reliability problem arise due to the spiking during metallization process, which reduces the breakdown voltage and reduces overall yield. Even with the trench Schottky technology, which allows obtain higher breakdown voltage, practical SBD's are limited to breakdown voltages below 250V. The PN-junction technology is typically used for higher voltages. They provide usually higher $V_F$ (above 0.7V) and thus lower efficiency, but higher reliability. However, due to carrier density modulation they can withstand large current surges. Also since the maximum electric field is at the PN junction and not at the surface as in a SBD, the metallization spikes do not cause the early breakdown problem.

Other approaches, based on the field effect under an MOS gate, have been proposed in order to combine the high efficiency of a SBD with the high reliability of PN junction diodes. For example, in Pseudo- Schottky Barrier diodes and super barrier rectifiers, the potential barrier is created in the bulk of the semiconductor under the gate via processing (e.g. implantation, diffusion, oxidation etc.). The channel under the MOS gate is only weakly inverted and can be viewed as a barrier for majority carriers. The height of this barrier can be controlled by the gate thickness and the doping concentration under the gate. The presence of the barrier results in rectifying behavior similar to the SBD. SBD's can have a fixed barrier height, corresponding to the metals that make good contact with silicon, while in other prior art devices, the barrier height can be continuously changed. Short channel length and good control of the doping in the channel region are essential to making practical devices. The low voltage (breakdown below 100V) super barrier rectifiers have been shown to combine high reliability (similar to PN-junction diodes) and high efficiency.

However, many high voltage versions of such prior art devices (rated above 150V) exhibit negative differential resistance. Any negative resistance region can be useful to make oscillators, but in rectifiers this is undesirable behavior and needs to be avoided. Thus these prior art devices suffer from significant limitations at high voltages.

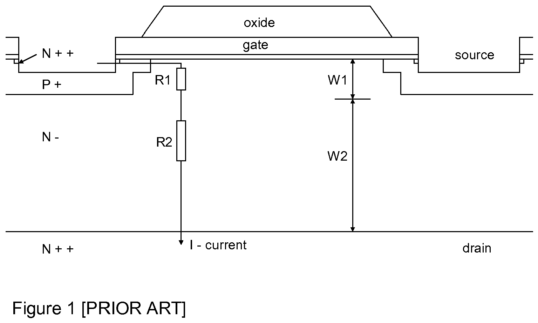

To overcome the inability of the prior art to operate reliably at high voltages, it is important to control the negative resistance region, which can involve either an increase or a decrease, depending upon other factors. The source of the negative resistance is the rapid reduction of the drift region resistivity due to the injected carriers. As shown in Figure 1 , which depicts a model of a typical prior art field effect barrier rectifier, the total drift region resistance is typically modeled as being divided into two parts, $R_1$ and $R_2$ The top resistance, $R_1$, typically controls the voltage on the P-N junction, and bottom $R_2$. Once the sum of voltage drops on the resistor $R_1$ and the channel is above the knee voltage V* of the P-N junction, the holes can be injected from P-N junction to the drift region. To maintain quasineutrality the electrons are injected from the substrate. This rapidly growing carrier concentration reduces the resistivity of the drift region and the voltage drop on resistor $R_2$. This voltage drop on the drift region can lead to the negative resistance. The negative resistance can be effectively controlled by varying resistor $R_1$ because it changes the critical current when the injection starts (I*), and because the slope of negative resistance depends on the ratio of $R_2/R_1$. Thus the $R_1$ reduction increases the negative resistance region and the $R_1$ increase reduces the negative resistance region.

$$\frac{R_1}{R_2} = \frac{N_{D1}A_1W_2}{N_{D2}A_2W_1}$$

where $A_2$ is the total area of the drain region and $A_1$ is smaller since current cannot flow through the P region. $W_1$ is close to the thickness of the P region and $W_2$ is the

distance between the P region and substrate. The required breakdown voltage sets the donor concentration in the bottom epitaxial region ($N_{D2}$), but the donor concentration in the top region ($ND_1$) can be adjusted.

One of the ways to control negative resistance in Field Effect Rectifiers is to adjust the donor concentration in the top layer, which was analyzed in Rodov V., Ankoudinov A.L., Ghosh P., Solid State Electronics 2007; 51 :714-718. There a reduction of $N_{D1}$ twice, by the use of a double layer epitaxial structure, was enough to remove negative resistance from the I-V curve. However, this solution of the negative resistance problem may be not the best practical approach, since it is more difficult to manufacture double layer epitaxial structures.

Another major concern is how fast the diode can be switched from forward current conduction to reverse current blocking. One of the major concerns in reverse recovery is the storage time which depends at least in part on how much charge is present in the barrier region. It takes some time to remove this charge, before the depletion layer can be developed to support reverse voltage. The total stored charge still largely determines the total reverse recovery, however some reasonable amount of storage charge is useful since it can provide soft recovery and reduce electro-magnetic interference problems. Thus the softness of reverse recovery is affected by the total stored charge and junction capacitance. To optimize diode reverse recovery it is helpful to be able to quickly deplete the channel region and to be able to trade off between speed of reverse recovery and electromagnetic emissions.

A brief overview of the prior art leads to following conclusions:

Field Effect Diodes provide a good combination of performance and reliability which cannot be achieved by conventional Schottky or PN-junction technologies.

To avoid negative resistance, prior art Field Effect Diodes typically need special means to adjust the top layer resistance.

The ability to rapidly deplete the channel region and operate at high frequency without large electromagnetic interference is desirable in at least some embodiments.

## SUMMARY OF THE INVENTION

The present invention comprises an Adjustable Field Effect Rectifier (sometimes "AFER" hereinafter) device having an adjustment pocket or region which permits the device to function reliably and efficiently at high voltages without the negative resistance of prior art devices, while also permitting fast recovery and operation at high frequency without large electromagnetic interference. The process for fabricating a device according to the invention comprises opening the gate oxide followed by ion implantation to create a dopant concentration below that opening. The opening can be covered by oxide, if contact between the doped region and the metal is not desired.

The introduction of the adjustment pocket of the present invention gives a much more flexible device design because it allows modification of the top layer resistance during processing. In some embodiments, it is desirable to increase the top layer resistance, which can be accomplished by a P+ implantation into the pocket. Alternatively, an N+ implantation is used to decrease the top layer resistance. For high voltage devices, the P+ implant is useful to remove negative resistance and thus correct Field Effect rectifier performance. The N+ implant is useful to improve the performance of low voltage diodes. Additional advantages of the adjustment pocket structure are to allow the reduction of the junction capacitance and of the charge stored in the channel area, thus improving the reverse recovery characteristics of the diode.

The present invention can be better understood from the following Detailed Description of the Invention, taken in combination with the appended Figures, as described below.

According to an aspect there is provided an adjustable field effect rectifier comprising an epitaxial layer (of a first conductivity with a drain formed on one side of the epitaxial layer, a pair of wells of a second conductivity, opposite to the first conductivity, spaced apart from one another, formed in the epitaxial layer opposite the drain, a gate area formed atop the epitaxial layer opposite the drain, an opening through the gate area, and a layer of the first conductivity formed in the epitaxial layer under the opening shorted to the gate and the pair of wells, said layer is configured to decrease a resistance of a top layer within the epitaxial layer between the pair of wells and the layer.

The adjustable field effect rectifier may comprise oxide sidewalls in the opening on the layer of the first conductivity and against the gate area.

The first conductivity may be that of a n-type material, and the second conductivity may be that of a p-type material.

The first conductivity may be that of a p-type material, and the second conductivity may be that of a n-type material.

The adjustable field effect rectifier may further comprise a first contact connected to the gate area, the layer formed under the opening, and the pair of wells, and a third contact connected to the drain.

According to another aspect there is provided a method of forming an adjustable field effect rectifier comprising providing an epitaxial layer of a first conductivity with a drain formed on one side of the epitaxial layer, forming a pair of wells of a second conductivity, opposite to the first conductivity, spaced apart from one another, in the epitaxial layer opposite the drain, forming a gate area formed atop the epitaxial layer, etching an opening through the gate area, and forming a layer of the first conductivity in the epitaxial layer under the opening shorted to the gate and the pair of wells, said layer is configured to decrease a resistance of a top layer within the epitaxial layer between the pair of wells and the layer.

The method may further comprise forming oxide sidewalls in the opening on the layer of the first conductivity and against the gate area.

The first conductivity may be that of a n-type material, and the second conductivity may be that of a p-type material.

The first conductivity may be that of a p-type material, and the second conductivity may be that of a n-type material.

The method may further comprise forming a first contact connected to the gate area, the layer (formed through the opening, and the pair of wells, and forming a third contact connected to the drain.

According to an aspect there is provided an adjustable field effect rectifier comprising an epitaxial layer of N conductivity, a pair of P wells, spaced apart from one another, formed in the epitaxial layer, a gate area formed atop the epitaxial layer, an opening through the gate area, and a P layer formed in the epitaxial layer through the opening.

According to an aspect there is provided an adjustable field effect rectifier comprising an epitaxial layer of a first conductivity and forming a drain on one side thereof, a pair of wells of a second conductivity, opposite to the first conductivity, spaced apart from one another, formed in the epitaxial layer opposite the drain, a gate area formed atop the epitaxial layer opposite the drain, an opening through the gate area, a layer of a second conductivity formed in the epitaxial layer through the opening, a first contact connected to the gate area, the layer formed through the opening, and one of the pair of wells, a second contact connected to the second of the pair of wells, and a third contact connected to the drain.

## THE FIGURES

Figure 1 illustrates a prior art structure of the Field Effect barrier rectifier. Oxide on the top is a remnant of the self-alignment process and represents a problem for metal adhesion and thermal heat removal. Resistance R1 needs to be reduced to address negative resistance problem.

Figure 2 illustrates an embodiment of the Adjustable Field Effect Rectifier (AFER) in accordance with the invention. Resistance $R_1$ is reduced by the geometry and resolves the negative resistance problem. The embodiment also promotes better thermal and electrical contact.

Figure 3 is a schematic representation of an embodiment of an AFER as a MOSFET with gate electrode shorted to the source. Polarity of the diode is the same as that of the MOSFET intrinsic body diode.

Such shorted MOSFET will not always function as an efficient diode, and structural parameters (gate oxide thickness, channel length, etc.) need to be chosen carefully.

Figure 4 illustrates the operation of the AFER. During forward bias the depletion layers from various P-regions do not overlap (shown by dashes) and electrons can easily flow from the channel region to the drain. During reverse bias depletion layers grow in size and after pinch-off start to overlap (see dash-dots). This pinch-off effect helps to reduce the leakage of the device.

Figure 5 illustrates in graphical form forward current density versus applied voltage for an embodiment of a 600 V AFER. The structure without adjustment area exhibits negative resistance (leftmost curve at V axis). Introduction of the adjustment area 0.25um (middle curve at V axis) or 0.35um (rightmost curve at V axis) wide fixes the problem. The width and doping concentration in the adjustment area can be used also to improve device performance at low current density.

Figures 6-16 illustrate processing steps for fabricating an embodiment of the invention. In particular, Figure 6 shows an intermediate structure after vertical etching through the polysilicon gate and gate oxide (can leave some of gate oxide to reduce the channeling) using the Gate mask.

Figure 7 illustrates a cover mask placed on the Gate mask to cover the adjustment area opening.

Figure 8 illustrates the structure of an embodiment after a P+ well boron implant and contact arsenic implant are performed.

Figure 9 illustrates a trench etched in silicon to provide ohmic contact to the P-well. Notice that only small portion of implanted As is left.

Figure 10 illustrates an embodiment after both masks are isotropically etched. This self-aligning step provides uniform barrier height throughout the device.

Figure 11 illustrates an embodiment after channel boron is implanted. The Implantation dose determines the potential barrier height inside the channel. It is desirable to use a self-aligning process in at least some embodiments to help ensure having the same barrier height throughout the chip.

Figure 12 shows an embodiment after the Gate and Cover masks are removed. Contact boron is implanted. If the dose is high, the barrier height in the adjustment area is higher than in the channel region. In this case it can be a final structure. Otherwise, oxide or oxide walls can be put in the adjustment area, as shown below.

Figure 13 shows an embodiment after the insulating oxide layer is deposited. The Cover mask is placed to keep oxide in the adjustment area.

Figure 14 shows an embodiment after the oxide is etched.

Figure 15 shows an embodiment after the cover mask is removed. It can used as a final structure in some implementations, which prevents any current through the adjustment area. This is the structure if adjustment area implant type was the same as EPI type in order to reduce resistor (in this case contact implant can be done before Cover mask is placed for the first time- see Fig.1).

Figure 16 shows an embodiment where the oxide is vertically etched to leave just the oxide sidewalls, and can be the final structure for some embodiments. This final structure is preferred when the contact implant is of the opposite type than the EPI type. Without an oxide side wall the potential barrier under the gate in the adjustment area can be too small in some implementations.

## DETAILED DESCRIPTION OF THE INVENTION

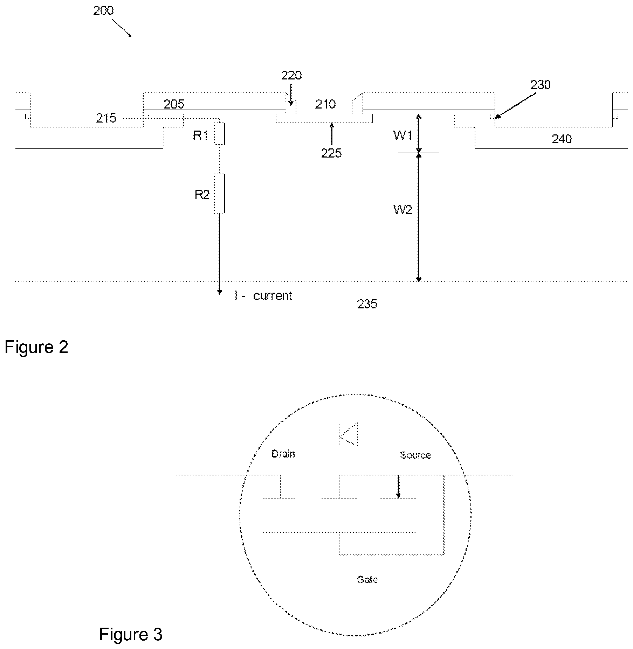

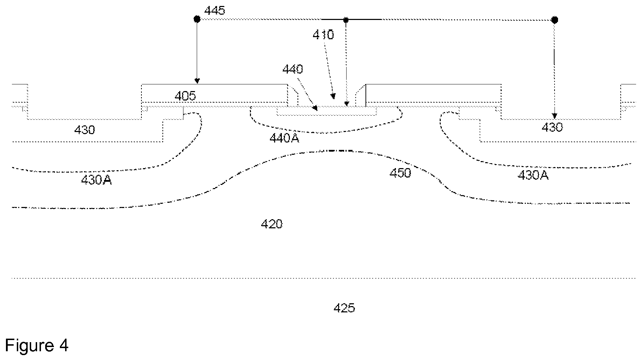

Referring first to Figure 2, an embodiment of an Adjustable Field Effect Rectifier (sometimes abbreviated as "AFER" hereinafter for simplicity) in accordance with the invention is shown generally at 200, and in the illustrated arrangement includes an adjustment area, or pocket, discussed in greater detail hereinafter. The barrier for the carrier transport is created under the MOS gate 205 due to the field effect. The barrier height is controlled by the gate material, the gate oxide thickness and the doping concentration in the semiconductor under the gate. A pocket 210 is etched in the middle of the gate, and a shallow P+ implant is created under that opening, which can be insulated from the source 215 via oxide layer 220 or directly connected to the source electrode (for faster performance). The described arrangement is depicted in Figure 2. For clarity the connection between the source, gate and pocket area is omitted from Figure 2, but is included in Figure 4. The connection is typically implemented by a conductive layer, such as a metal layer, for example. The shallow P+ implant 225 restricts the current flow of majority carriers, thus increasing the top layer resistance $R_1$. Those skilled in the art will appreciate that the device of the present invention can be either N-type or P-type, depending upon the substrate and related processing. For purposes of clarity, an N-type substrate is described hereinafter, but is not to be considered limiting.

The adjustment pocket 210 comprises an opening 225 in the gate 205, into which a dopant is implanted. In some embodiments, the adjustment pocket can also comprise an oxide over the opening 220 to assist in ensuring that no significant current can pass through adjustment area. In at least some embodiments, it is desirable to have substantially identical resistors from both sides of the gate opening, to prevent one side from becoming less active during operation. Such an imbalance can cause deterioration in device performance. To facilitate creating substantially equal resistance on both sides of the gate, a self-aligning processing is used in an embodiment.

The small N+ contact 230 provide the ohmic contact to the metal for electrons flow. In some embodiments, the N+ contact can be avoided if the Schottky barrier height at the contact is smaller than the barrier height under the gate. In such an embodiment the rectifying behavior is determined by the channel barrier and not the Schottky barrier height. The N++ substrate 235 provides ohmic contact on the backside of the structure and provides as many electrons as holes generated by the P-well 240, thereby maintaining quasineutrality.

In a simplified view, the AFER structure of the present invention resembles the structure of a MOSFET, with the gate shorted to the source. Thus a MOSFET's electric circuit symbol can be modified to represent the AFER device, as shown in Figure 3. However, in order to function as an efficient rectifier in accordance with the present invention, the structural parameters (gate oxide thickness, channel length, distance between channels, etc.) are significantly modified, including substantial removal of a layer of oxide that, in the prior art, would insulate the gate and source. In addition, the adjustment area is added, and is also shorted to the gate and the source. The result is that the structure of the present invention behaves as a high performance diode which does not exhibit negative resistance. The polarity of that resulting diode is the same as that of the intrinsic body diode. Thus for an N-type device the source electrode will become anode of the diode, and for a P-type device the source will be cathode of the diode.

Referring next to Figure 4, in forward bias, the current flows from the top source electrode 410 horizontally under the gate 405 to get over the channel barrier for carrier transport. Then the current spreads through the N- epitaxial layer 420, changes to a mostly vertical direction, and flows toward the drain electrode 425. The depletion layers of the P-well 430 and shallow P implant 440 (dashed lines 430A and 440A on Figure 4) do not overlap, but restrict current flow to a narrow region and determine resistance $R_1$. The vertical intrinsic PN diode 430 does not play any role until the combined voltage drop on the channel and resistance $R_1$ reaches the "knee" voltage (about 0.6V). Above that voltage the P-well 430 injects holes into the N-epitaxial layer 420, which leads to conductivity modulation and provides the field effect rectifier of the present invention with the ability to handle large forward surge current.

During reverse bias, and because of the connection 445 shown between the source, gate and pocket area, the depletion layers 430A and 440A around the P-well 430 and P-pocket 440 grow in size and eventually start to overlap as shown at dotted dashed curve 450 on Figure 4. It will be appreciated by those skilled in the art that the curve 450 can be thought of as an equipotential line that serves to describe the growth of the depletion layer during reverse bias. This determines a leakage current of the device. For the higher applied reverse bias the depletion layer behavior is similar to that of the PN junction diode. Note that P-pocket promotes the earlier pinch-off and lower leakage current of the device.

In at least several embodiments, the adjustment pocket provides several important improvements to device performance during the switching between forward and reverse bias. Since part of the gate is removed, junction capacitance is automatically reduced. This also means that fewer carriers will be accumulated under the gate when the device is forward biased. This further reduces the storage time that has to elapse before the depletion layer starts to develop during reverse recovery. Thus, in an embodiment, the traditional methods for controlling carrier lifetime (e.g. electron irradiation), together with the adjustment pocket, allows optimization for reverse recovery, which in turn permits operation at maximum frequency with minimum electromagnetic interference.

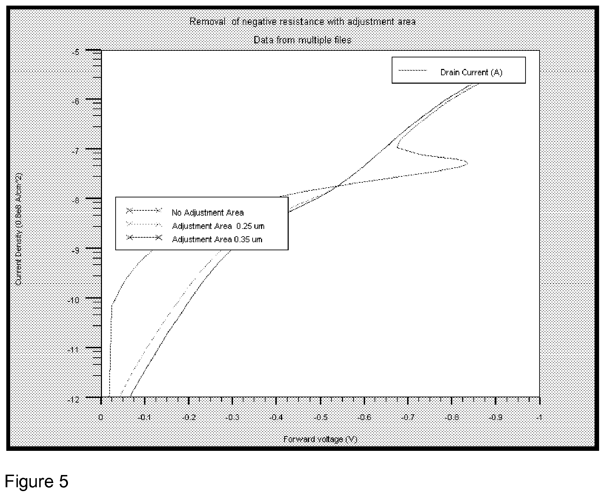

As illustrated in Figure 5, in at least some embodiments the adjustment region also provides adjustment of the top resistor to avoid negative resistance in high voltage AFERs. The leftmost curve at the V axis shows the I-V characteristic of the diode without the adjustment area of the present invention, and exhibits negative resistance. The middle curve at the V axis shows the I-V curve for the same device parameters with an adjustment area of 0.25 $\mu$m added in accordance with the present invention, and shows no trace of the negative resistance. The rightmost curve at the V axis shows the I-V curve for a device with 0.35 $\mu$m, and also shows elimination of the negative resistance. This method of controlling negative resistance has the advantage that uniform dopant concentration can be used, which is simpler to manufacture.

Low voltage devices, with a breakdown voltage below 100 volts, typically do not have the negative resistance problem. To optimize these structures, it is desirable to minimize the forward voltage of the device while keeping leakage at acceptable level. In some embodiments, the adjustment region also helps such optimization by including an N+ pocket implant to reduce the resistance modeled as resistor $R_1$ in Figure 2. In these embodiments a thick oxide is preferably deposited in the adjustment pocket, to prevent the current flow through the pocket. This step is included within the process flow discussed below, although it is not required in all embodiments.

Those skilled in the art will appreciate that the AFER structure described above provides improvements in reverse recovery as well as controlling the value of the top resistance $R_1$. As discussed above, an increased value of $R_1$ is useful for high voltage devices to solve the negative resistance problem, while a reduced value of $R_1$ can be used to improve efficiency of the low voltage devices.

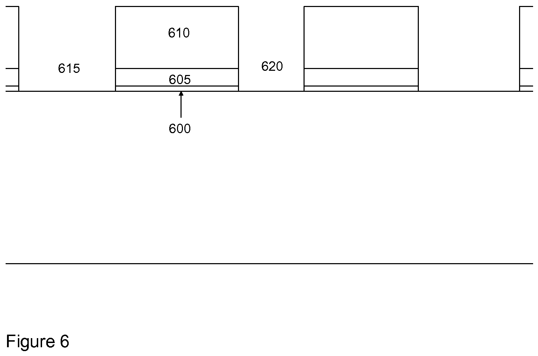

Referring next to Figures 6-16, generally, one embodiment of a process for manufacturing AFER devices can be better appreciated. It is assumed that an epitaxial layer has been grown on a substrate, together with the following steps that are typical of production of semiconductor devices and so are not shown in detail. The breakdown voltage can be adjusted by varying the doping concentration (N-type) and the thickness of this epitaxial layer. A guard ring (GR) structure, on the order of 0.5 to 5 $\mu$m in at least some embodiments, is built using one of the standard methods, and a field oxide is formed by either thermal oxidation, CVD of silicon oxide, a combination of the two, or any other suitable method. The guard ring mask is used to open a window in the field oxide, through which a P-well implant is introduced, followed by thermal diffusion. The field mask is then used to open a window in the field oxide for fabrication of the active area of the device.

Referring particularly to Figure 6, a gate oxide 600 is grown to on the order of 30-200 A, following by growing a layer of polysilicon 605 on the order of 600-1200 A. A gate mask 610 is then developed, after which the polysilicon 605 is vertically etched, resulting in the structure shown in Figure 6 with openings 615 and 620. If a reduction of the resistance shown as $R_1$ in Figure 2 is desired for the particular embodiment, a contact arsenic (As) implantation can be done at this stage through the openings 615 and 620.

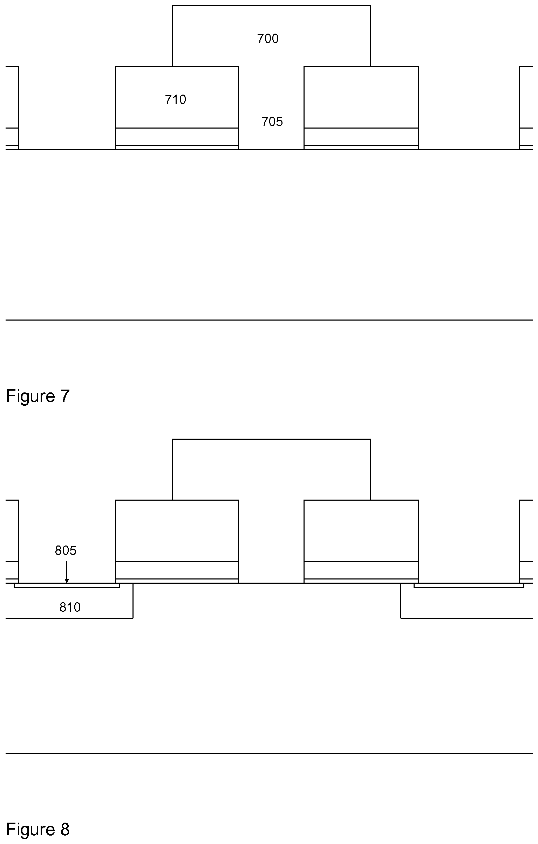

Referring next to Figure 7, a second cover mask 700 is made on top of the gate mask 710 to cover the adjustment pocket 705. In some embodiments, it is desirable to adhesively affix the gate mask to the wafer, or, alternatively, to fabricate the gate mask from silicon nitride or other suitable material. This masking arrangement facilitates use of self-aligning process with uniform barrier heights and $R_1$ values throughout the entire area of the device.

Referring next to Figure 8, the contact arsenic implant 805 and P-well boron are implanted, resulting in P-wells 810. In some embodiments, the dose of P-well boron is selected to be high enough to restrict the main current flow through the channel area.

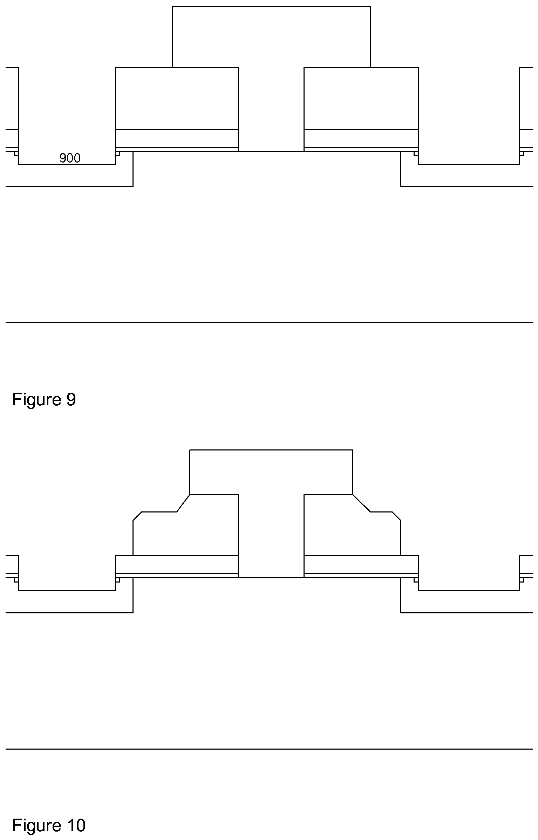

Referring next to Figure 9, a contact well 900 is vertically etched into the silicon to provide contact to the P-well. In the absence of such a contact, the charge in the P-well can be affected by the hole current that flows to the anode through the P-wells of the guard ring structure. In some instances, this may slow down device operation. The contact wells help to optimize the use of the active device area and allow holes from P-well to flow directly to the source electrode. In addition, sufficient ohmic contact is preserved to allow for the flow of electrons, since most of the electron current is flowing through the narrow channel under the gate. It will be appreciated by those skilled in the art that, in some embodiments, only a small portion of the implanted As remains after formation of the contact wells.

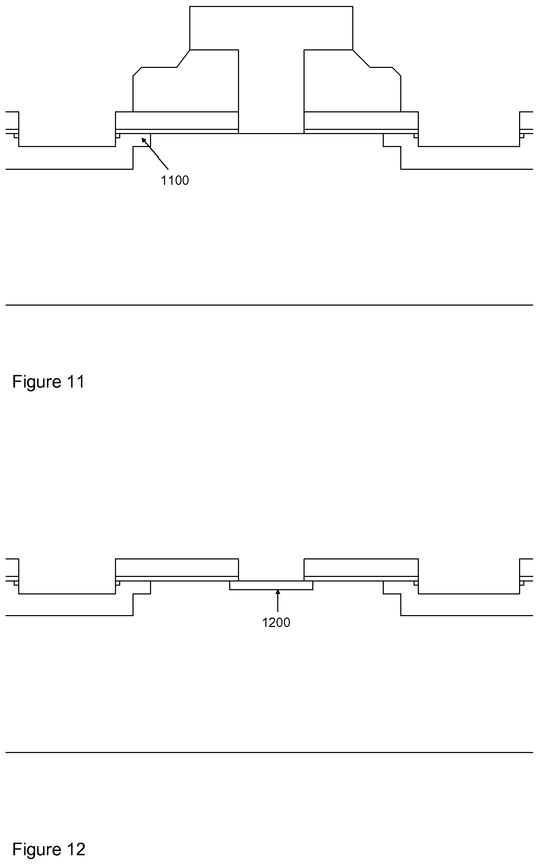

Referring next to Figure 10, the gate mask 710 and the cover mask 700 are isotropically etched, which provides a self-aligned mask for a channel boron 1100 implantation shown in Figure 11, thus helping to assure uniform barrier height throughout the relevant portion of the device. The cover mask is also etched at this stage, while still covering the adjustment area.

Referring to Figure 12, the gate and cover masks are removed, followed by a P-type pocket 1200 implant to increase the resistance $R_1$ of the top region, to restrict current flow.. In some embodiments, and particularly those where the doping concentration under the gate in the adjustment pocket is larger than that in the channel region, the structure shown in Figure 12 is the final structure. This can make further processing steps unnecessary.

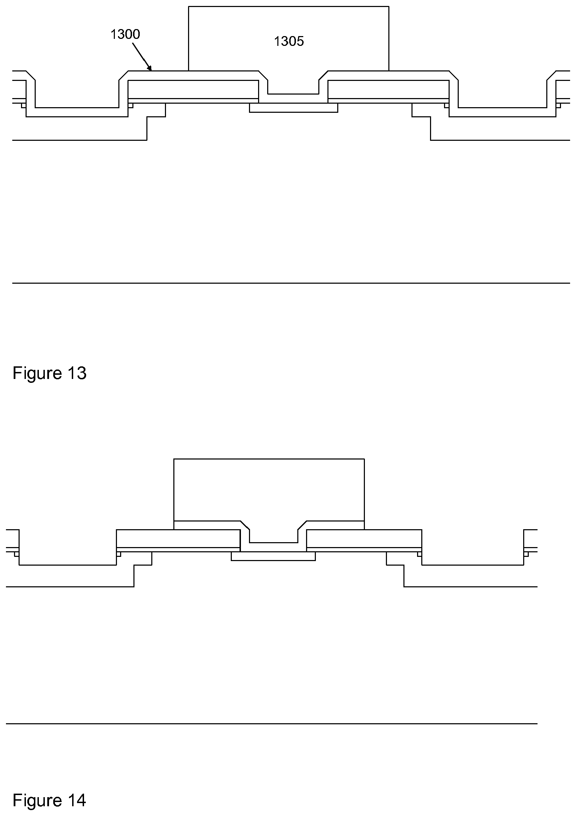

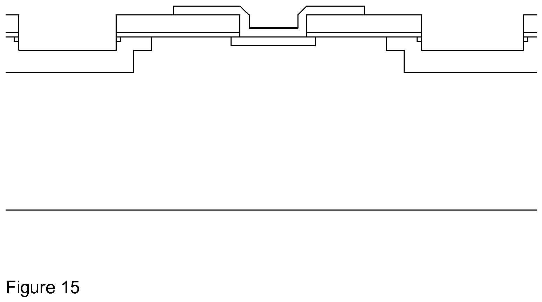

However, in some embodiments, it is desirable to further develop the adjustment pocket by adding oxide sidewalls or a layer of oxide. This is shown beginning with Figure 13, where a layer of oxide (identified by numeral 1300) on the order of 50-500 A thick is deposited, followed by placement of a cover mask 1305. Then, referring to Figure 14, the oxide is vertically etched, followed by removing the cover mask 1305, shown in Figure 15. Figure 15 depicts the final structure for those embodiments where the resistance shown as $R_1$ in Figure 2 is to be reduced, and an N-type implantation was made in the adjustment area. This approach permits reduction of R1 while also preventing electrons from flowing to the source through the opening of the adjustment area.

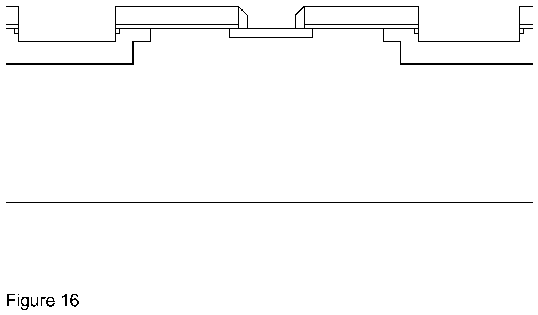

Next, as shown in Figure 16, the oxide is vertically etched until only the oxide sidewalls are left. This structure depicts the final structure if the value of $R_1$ is to be increased, together with the use of P-type implantation in the adjustment area. This structure permits holes from the P- contact in the adjustment area to flow to the source electrode, thus allowing for fast operation, while at the same time limiting electron flow to the source only through the channel region.

Having fully described an embodiment of the invention, together with numerous alternatives and equivalents, those skilled in the art will appreciate that numerous alternatives and equivalents exist which do not depart from the invention and are intended to be included within its scope. As a result, the invention is not to be limited by the foregoing description.

**Claims**

1. An adjustable field effect rectifier (200) comprising an epitaxial layer (420) of a first conductivity with a drain formed on one side of the epitaxial layer (420), a pair of wells (240, 430) of a second conductivity, opposite to the first conductivity, spaced apart from one another, formed in the epitaxial layer (420) opposite the drain, a gate area (205, 405, 605) formed atop the epitaxial layer (420) opposite the drain, an opening (210, 410) through the gate area (205, 405, 605), and a layer (225, 440, 1200) of the first conductivity formed in the epitaxial layer (420) under the opening (210, 410) shorted to the gate and the pair of wells, said layer (225, 440, 1200) is configured to decrease a resistance of a top layer within the epitaxial layer (420) between the pair of wells (240, 430) and the layer (225, 440, 1200).

2. The adjustable field effect rectifier (200) of claim 1 comprising oxide sidewalls (220) in the opening (220) on the layer (225, 440, 1200) of the first conductivity and against the gate area (205, 405, 605).

3. The adjustable field effect rectifier (200) of claim 1 or claim 2 where the first conductivity is that of a n-type material, and the second conductivity is that of a p-type material.

4. The adjustable field effect rectifier (200) of claim 1 or claim 2 where the first conductivity is that of a p-type material, and the second conductivity is that of a n-type material.

5. The adjustable field effect rectifier (200) of any preceding claim, further comprising a first contact (445) connected to the gate area (205, 405, 605), the layer (225, 440, 1200) formed under the opening (410), and the pair of wells (240, 430), and a third contact connected to the drain (235, 425).

6. A method of forming an adjustable field effect rectifier (200) comprising providing an epitaxial layer (420) of a first conductivity with a drain formed on one side of the epitaxial layer, forming a pair of wells (240, 430) of a second conductivity, opposite to the first conductivity, spaced apart from one another, in the epitaxial layer (420) opposite the drain, forming a gate area (205, 405, 605) formed atop the epitaxial layer (420), etching an opening (210, 410) through the gate area (205, 405, 605), and forming a layer (225, 440, 1200) of the first conductivity in the epitaxial layer (420) under the opening (210, 410) shorted to the gate and the pair of wells, said layer (225, 440, 1200) is configured to decrease a resistance of a top layer within the epitaxial layer (420) between the pair of wells (240, 430) and the layer (225, 440, 1200).

7. The method of claim 6 further comprising forming oxide sidewalls (220) in the opening (220) on the layer (225, 440, 1200) of the first conductivity and against the gate area (205, 405, 605).

8. The method of claim 6 or claim 7 where the first conductivity is that of a n-type material, and the second conductivity is that of a p-type material.

9. The method of claim 6 or claim 7 where the first conductivity is that of a p-type material, and the second conductivity is that of a n-type material.

10. The method of claims 6 to 9, further comprising forming a first contact (445) connected to the gate area (205, 405, 605), the layer (225, 440, 1200) formed through the opening (210, 410), and the pair of wells (240, 430), and forming a third contact connected to the drain (235, 425).

Figure 1 [PRIOR ART]

Figure 2

Figure 3

Figure 4

Figure 5

610

615

605

620

600

Figure 6

700

710

705

Figure 7

805

810

Figure 8

Figure 9

Figure 10

1100

Figure 11

1200

Figure 12

1300

1305

Figure 13

Figure 14

Figure 15

Figure 16

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 60975467 B
- US 60022968 B
- US 61048336 B

### Non-patent literature cited in the description

- **RODOV V. ; ANKOUDINOV A.L. ; GHOSH P.** *Solid State Electronics,* 2007, vol. 51, 714-718